Europäisches Patentamt

European Patent Office

Office européen des brevets

(19)

(11) Numéro de publication : **0 146 458 B1**

(12) **FASCICULE DE BREVET EUROPÉEN**

(45) Date de publication du fascicule du brevet :
28.09.88

(51) Int. Cl.⁴ : **H 05 K 3/36, H 01 R 9/09**

(21) Numéro de dépôt : **84402485.1**

(22) Date de dépôt : **04.12.84**

(54) Dispositif d'interconnexion électrique de cartes de circuit imprimé.

(30) Priorité : 09.12.83 FR 8319759

(43) Date de publication de la demande :
26.06.85 Bulletin 85/26

(45) Mention de la délivrance du brevet :
28.09.88 Bulletin 88/39

(84) Etats contractants désignés :
DE GB IT SE

(56) Documents cités :
GB-A- 2 006 550
US-A- 3 197 766
US-A- 3 812 381
US-A- 3 832 603

(73) Titulaire : ALCATEL ESPACE
11, avenue Dubonnet
F-92407 Courbevoie Cédex (FR)

(72) Inventeur : Sauvagnac, Roland
Thomson-CSF SCPI 173, bld. Haussmann
F-75379 Paris Cedex 08 (FR)
Inventeur : Zagonel, Jean-Pierre
Thomson-CSF SCPI 173, bld. Haussmann
F-75379 Paris Cedex 08 (FR)
Inventeur : Fiat, Michel
Thomson-CSF SCPI 173, bld. Haussmann
F-75379 Paris Cedex 08 (FR)

(74) Mandataire : Weinmiller, Jürgen et al
Lennéstrasse 9 Postfach 24
D-8133 Feldafing (DE)

## Description

La présente invention concerne un dispositif d'interconnexion électrique de cartes de circuit imprimé selon le préambule de la revendication 1.

Pour réaliser la connexion de cartes de circuit imprimé entre elles, un procédé connu consiste à fixer sur les cartes des connecteurs et à réaliser une interconnexion des broches des connecteurs au moyen d'un plancher d'interconnexion.

Le procédé précité présente l'inconvénient d'être mal adapté aux réalisations modulaires consistant à assembler des ensembles électroniques à partir de cartes de circuit imprimé choisies dans un standard où chaque type de carte est défini par sa fonction spécifique, car toute permutation dans l'ordre des cartes, ou tout changement dans la nature des cartes mises en œuvre, entraîne des modifications du câblage du plancher d'interconnexion ou du raccordement des circuits imprimés à leur connecteur, ce qui par voie de conséquence augmente les temps d'étude et de mise au point des réalisations obtenues par ce procédé.

Le procédé précité a aussi pour inconvénient de conduire à des réalisations de poids non négligeables et volumineuses préjudiciables à certains domaines d'applications où la réduction du poids et du volume sont recherchés, en particulier lorsque ces réalisations sont destinées à faire partie d'équipements pour satellites de télécommunication.

Le but de l'invention est de pallier les inconvénients précités.

A cet effet l'invention a pour objet, un dispositif d'interconnexion de cartes de circuit imprimé, maintenues dans des positions fixes les unes par rapport aux autres, le dispositif comprenant des connecteurs fixes chacun à une carte de circuit imprimé, chaque connecteur étant constitué par un bloc support en matériau diélectrique et une ou plusieurs broches métalliques de connexion partagées chacune en au moins deux parties, une première partie étant fixée au bloc support et la deuxième partie étant en saillie sur le bloc support, caractérisé en ce que chaque deuxième partie d'une broche d'un connecteur traverse le circuit imprimé de la carte à laquelle son bloc support est fixé au travers d'un trou métallisé pour réaliser une connexion entre la broche et au moins un conducteur du circuit imprimé, et a une longueur ajustable pour permettre dans une première situation sa mise en contact directe avec la première partie d'une broche en regard d'un connecteur d'un circuit imprimé adjacent ou dans une deuxième situation sa séparation de la broche en regard du connecteur du circuit imprimé adjacent.

Selon une caractéristique préférée de l'invention, chaque circuit imprimé supporte une première série de plots de connexion reliés électriquement respectivement à une broche de connexion et une deuxième série de plots de connexion reliés électriquement chacun à au moins un conducteur du circuit imprimé, pour permettre la connexion à volonté des broches de connexion aux conducteurs du circuit imprimé reliés aux plots de la deuxième série au moyen de fils conducteurs reliant les plots de la première série aux plots de la deuxième série.

Le dispositif de connexion selon l'invention a pour principal avantage qu'il permet des réalisations d'unités électroniques entièrement modulaires, chaque module comprenant une carte de circuit imprimé à une ou plusieurs couches munie du connecteur de l'invention. Il permet également d'obtenir des ensembles électroniques compacts de faible volume par empilage des modules les uns contre les autres tout en rendant possible des inversions dans l'ordre de ceux-ci, ou l'adjonction de modules supplémentaires sans que ceci implique des modifications dans les dessins des conducteurs des circuits imprimés, lorsqu'en cours d'étude ou de mise au point des unités électroniques une permutation dans l'ordre des modules, une adjonction ou une suppression de module s'avère nécessaire.

D'autres caractéristiques et avantages de l'invention apparaîtront également à l'aide de la description qui va suivre faite au regard des dessins annexés qui représentent :

- la figure 1 une vue en coupe d'un mode de réalisation d'un connecteur selon l'invention ;

la figure 2 une vue en coupe d'une variante de réalisation d'un connecteur selon l'invention comportant des broches de connexion amovibles ;

la figure 3 une vue en coupe d'un ensemble modulaire obtenu par empilement de plusieurs connecteurs et de leurs circuits imprimés, selon l'invention ;

la figure 4 un exemple de réalisation d'une interconnexion d'un circuit imprimé aux broches de son connecteur ;

la figure 5 une vue en coupe d'un exemple de réalisation d'un connecteur à broches amovibles courtes permettant l'interconnexion d'une broche à un conducteur de la carte sans interconnexion avec le connecteur de la carte précédente ;

la figure 6 un schéma d'interconnexion de plusieurs cartes reliées par le dispositif d'interconnexion de l'invention.

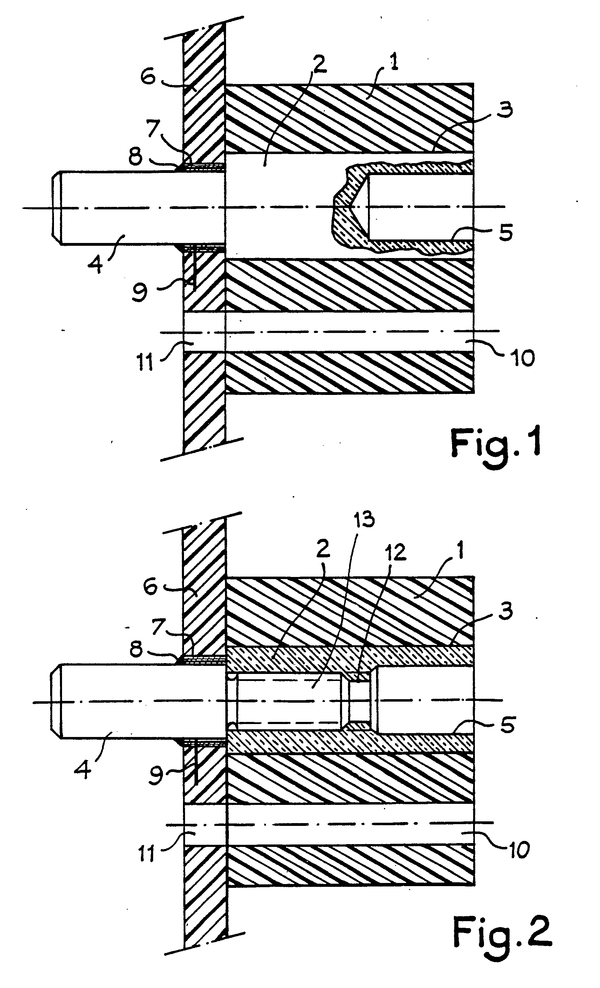

Le connecteur selon l'invention représenté à la figure 1 comprend un bloc support 1 en matériau diélectrique et un ensemble de broches de connexion 2 de dimensions approximativement identiques supportées par le bloc support 1, dont une seule apparaît sur la vue en coupe de la figure 1. Chaque broche de connexion 2 se compose de deux parties 3 et 4 aboutissant respectivement à une des deux extrémités d'une broche 2, la première partie 3 est fixée en étant noyée à l'intérieur du bloc support 1 et la deuxième partie 4, représentée sous la forme d'un épaulement cylindrique à une extrémité de la première partie 3, ressort en saillie du bloc support 1. La première partie 3 comprend à son extrémité non adjacente à l'épaulement 4 une partie évidée 5 sous la forme d'un trou cylindrique dont l'axe de révolution est confondu avec l'axe de révolution de l'épaulement 4 et dont le diamètre est légèrement supérieur au diamètre de l'épaulement 4 de manière à permettre l'engagement dans le trou 5 d'une autre partie 4 d'une autre broche 2 de mêmes dimensions appartenant à un autre connecteur. Le connecteur représenté à la figure 1 est placé sur une plaque de circuit imprimé multicouche 6, la connexion de chacune des broches 2 du connecteur au circuit imprimé étant obtenue par l'engagement de chaque deuxième partie 4, à l'intérieur d'un trou métallisé 7, le contact électrique de la deuxième partie 4 avec le trou métallisé 7 étant obtenu à l'aide d'un cordon de soudure 8. Le trou métallisé 7 réalise la liaison électrique entre la partie 4 de la broche 2 et un conducteur 9 du circuit imprimé multicouches 6. La fixation du bloc support 1 au circuit imprimé 6 est assurée par des trous 10 et 11 alignés pour permettre l'engagement d'un boulon de fixation, non représenté.

Une variante de réalisation du connecteur selon l'invention est représentée à la figure 2, où les éléments similaires au connecteur représenté à la figure 1 sont reproduits avec les mêmes références. Le connecteur représenté à la figure 2 diffère de celui de la figure 1 par le mode particulier de réalisation des broches de connexion dont les parties 3 et 4 sont amovibles l'une par rapport à l'autre. La première partie 3 de la broche 2 a la forme d'une douille percée d'un trou fileté 12 à l'extrémité opposée à celle pourvue du trou 5, l'axe longitudinal du trou fileté 12 étant confondu à l'axe longitudinal du trou 5. La partie 4 est filetée à une extrémité par un filetage 13 pour permettre son vissage dans le trou fileté 12 et réaliser la réunion des parties 3 et 4 ensemble. Naturellement le mode de fixation des parties 3 et 4 ensemble n'est pas limité à celui représenté à la figure 2 d'autres modes de fixation notamment par sertissage, clavetage, enclenchement au moyen par exemple de « clips » ou tous autres moyens équivalents sont en effet possibles. On comprendra également que la forme cylindrique donnée aux broches de connexion dans les exemples de réalisation des figures 1 et 2 n'est pas unique et que toutes les formes coniques parallélépipédiques, sphériques ou autres permettant le contact électrique des broches l'une dans l'autre sont également réalisables.

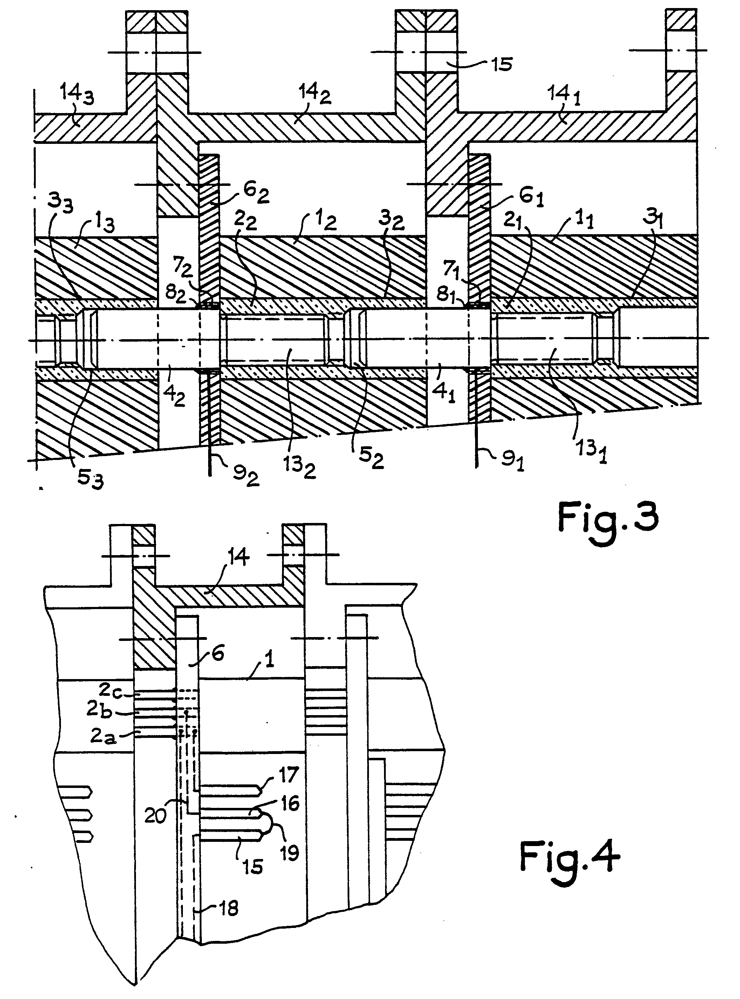

Un exemple d'utilisation de connecteurs du type de celui représenté à la figure 2 pour réaliser un ensemble modulaire formé par un empilement de plusieurs circuits imprimés est représenté à la figure 3. Sur la figure 3 chaque circuit imprimé $6_1$, $6_2$ représenté est fixé à un cadre métallique $14_1$, $14_2$, les connecteurs associés constitués par les blocs supports $1_1$ et $1_2$ et les broches de connexion $2_1$ et $2_2$ étant représentés enfichés l'un dans l'autre, la deuxième partie $4_1$ de la broche $2_1$ du connecteur de la carte de circuit imprimé $6_1$ étant engagée à l'intérieur du trou de

connexion $5_2$ de la broche de connexion $2_2$ du connecteur du circuit imprimé $6_2$, réalisant dans l'exemple représenté l'interconnexion entre le conducteur $9_1$ du circuit imprimé $6_1$ et le conducteur $9_2$ du circuit imprimé $6_2$. Des interconnexions semblables peuvent ainsi être obtenues de broche en broche entre chaque connecteur adjacent d'un ensemble modulaire de cartes de circuit imprimé, l'interconnexion se faisant toujours par insertion de la partie 4 d'une broche 2 dans le trou 5 d'une broche 2 d'un connecteur d'une carte adjacente. Les cadres métalliques 14 sont maintenus fixés les uns contre les autres par des boulons non représentés s'engageant dans les trous de fixation 15.

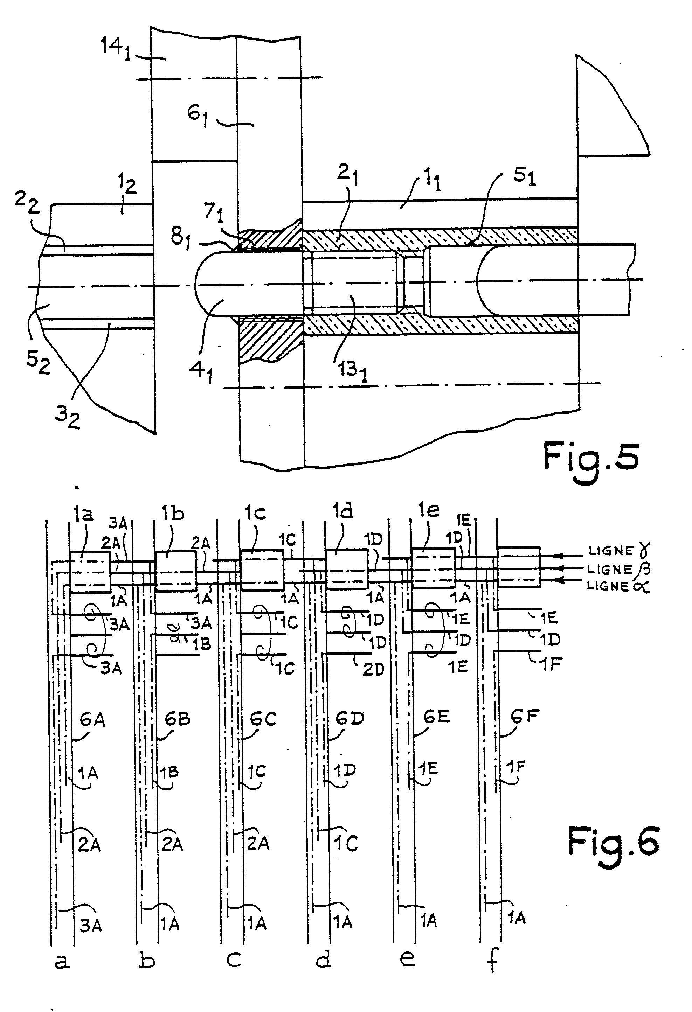

L'interconnexion d'une carte de circuit imprimé aux broches de son connecteur est maintenant décrite à l'aide de la figure 4. Sur la figure 4 un circuit multicouche 6 est représenté comme à la figure 5 sur un cadre support 14. Le circuit multicouche 6 supporte un réseau de plots de connexion tels que 15, 16 et 17 qui permet de réaliser des interconnexions entre les broches 2 du connecteur et les conducteurs intérieurs du circuit imprimé, distribuant ainsi de façon spécifique les signaux passant d'une carte à l'autre en laissant la possibilité d'effectuer des modifications importantes des interconnexions.

Dans l'exemple montré à la figure 4 le conducteur 18 intérieur au circuit imprimé est relié à une broche 2b par l'intermédiaire des plots de connexion 15 et 16 reliés électriquement ensemble par un fil conducteur 19 et par la liaison conductrice 20 intérieure au circuit imprimé 6 reliant le plot 16 à la broche 2b.

Malgré l'intérêt évident du réseau de plots de connexion, l'usage de ce réseau pour le transport de tous les signaux n'est pas obligatoire, il va de soi que certains signaux ou certaines tensions telles que les tensions d'alimentation des cartes de circuit imprimé pourront être distribuées sur un bus commun formé par une ou plusieurs lignes de broches alignées en contact les unes avec les autres dans l'ensemble des connecteurs sans transiter par le réseau de plots de connexion.

Selon une autre caractéristique de l'invention la longueur des deuxièmes parties 4 d'une broche est ajustable. En effet, pour prévenir les modes de réalisation où certains conducteurs d'une carte doivent être interconnectés seulement à des conducteurs de la même carte par le réseau de plots de connexion sans être interconnectés par le connecteur de l'invention aux circuits d'une carte adjacente, la deuxième partie amovible $4_1$ d'une broche reliée au conducteur par l'intermédiaire d'un plot de connexion peut dans ce cas avoir une longueur plus courte pour rendre impossible l'engagement et le contact de la deuxième partie amovible $4_1$ à l'intérieur d'un trou $5_2$ d'une broche directement en regard d'une carte adjacente comme ceci est représenté à la figure 5 pour les broches marquées $2_1$ et $2_2$.

Un schéma d'interconnexion de cartes de circuit multicouches obtenu avec le dispositif

d'interconnexion selon l'invention est montré à la figure 6 qui représente des modes de connexion en coupe dans le même plan perpendiculaire aux faces planes des circuits imprimés référencés de a à f. Dans l'exemple représenté le signal 1A est un signal commun distribué sur toutes les cartes par tous les connecteurs, le signal 2A est un signal distribué seulement sur les cartes a, b, c, la liaison avec les connecteurs des autres cartes étant coupée par la broche amovible du connecteur de la carte d qui a une dimension courte l'empêchant de rentrer en contact avec la broche directement en regard du connecteur de la carte c, le signal 1C est un signal transitant de la carte c à la carte d la liaison de la broche recevant ce signal étant coupée avec la broche correspondante de la carte b et étant également coupée avec la broche correspondante de la carte e, le signal 3A est un signal transitant de la carte a à la carte b sans aller sur les autres cartes car la liaison entre la broche correspondante recevant ce signal de la carte b avec l'ensemble des autres cartes cdef est coupée. On peut remarquer également que l'ensemble des broches interconnectées sur la ligne α de la figure 6 distribue sur toutes les cartes un signal commun alors que les broches situées sur les lignes β et α permettent les interconnexions particulières suivant la longueur grande ou petite des parties amovibles des broches 2 de chaque connecteur. Le dispositif qui vient d'être décrit permet de réaliser des permutations entre cartes sans que ces permutations entraînent des modifications dans les dessins et les circuits imprimés, dans le cas par exemple d'une permutation entre la carte e et la carte b le cheminement du signal 1A n'est pas affecté et les autres signaux peuvent être redistribués en intervenant seulement sur les liaisons entre les plots d'interconnexion des cartes concernées.

**Revendications**

1. Dispositif d'interconnexion de cartes de circuit imprimé ($6_1$, $6_2$), maintenues dans des positions fixes les unes par rapport aux autres, le dispositif comprenant des connecteurs fixés chacun à une carte de circuit imprimé, chaque connecteur étant constitué par un bloc support (1) en matériau diélectrique et une ou plusieurs broches métalliques de connexion partagées chacune en au moins deux parties (3, 4) une première partie (3) étant fixée au bloc support et la deuxième partie (4) étant en saillie sur le bloc support (1), caractérisé en ce que chaque deuxième partie (4) d'une broche d'un connecteur traverse le circuit imprimé de la carte à laquelle son bloc support est fixé au travers d'un trou métallisé (7) pour réaliser une connexion entre la broche et au moins un conducteur (9) du circuit imprimé, et a une longueur ajustable pour permettre dans une première situation sa mise en contact directe avec la première partie (3), placée en regard d'une broche d'un connecteur d'un circuit imprimé adjacent ou dans une deuxième situation sa séparation de la broche du connecteur placée en regard, du circuit imprimé adjacent.

2. Dispositif selon la revendication 1, caractérisé en ce que la première partie (3) de fixation d'une broche comprend une partie évidée (5) pour permettre l'insertion et le contact de la première partie (3) avec la deuxième partie (4) d'une autre broche.

3. Dispositif selon les revendications 1 et 2, caractérisé en ce que la partie évidée (5) est formée par un trou cylindrique et en ce que la deuxième partie (4) d'une broche est cylindrique et a un diamètre déterminé pour permettre le contact et son insertion à l'intérieur du trou formant la partie évidée (5) d'une autre broche.

4. Dispositif selon l'une quelconque des revendications 1 à 3, caractérisé en ce que la deuxième partie (4) d'une broche est fixée de façon amovible sur la première partie (3).

5. Dispositif selon l'une quelconque des revendications 1 à 4, caractérisé en ce que la deuxième partie d'une broche est vissée à la première partie (3).

6. Dispositif selon l'une quelconque des revendications 1 à 5, caractérisé en ce que chaque circuit imprimé comprend une première série de plots (15) de connexion reliés électriquement respectivement aux broches de connexions (2) et une deuxième série de plots (16) reliés électriquement chacun à au moins un conducteur du circuit imprimé pour permettre la connexion à volonté à l'aide de fils conducteurs des plots de la deuxième série aux plots de la première série.

7. Dispositif selon l'une quelconque des revendications 1 à 6, caractérisé en ce que les connecteurs comprennent des deuxièmes parties de broches (4) plus courtes que celles qui sont en contact avec les broches du connecteur du circuit imprimé adjacent pour permettre de réaliser l'interconnexion entre le conducteur de la carte sans réaliser l'interconnexion avec d'autres broches d'une carte adjacente.

**Claims**

1. A device for interconnecting printed circuit cards ($6_1$ $6_2$) maintained in fixed positions with respect to one another, the device comprising connectors, each mounted on a printed circuit card, each connector being constituted by a support base (1) made of dielectric material and one or several metal connector pins, each of which is divided into at least two portions (3, 4), a first portion (3) being attached to the support base and the second portion (4) projecting from the support base (1), characterized in that each second portion (4) of a connector pin crosses the printed circuit of the card to which its support base is attached through a metallized hole (7) in order to establish a connection between the pin and at least one conductor (9) of the printed circuit, and that it has an adjustable length for allowing, in a first situation, to contact directly the first portion (3) of an opposite pin of a connector of an adjacent printed circuit or, in a second situation, to be separated from the opposite pin of the connector of the adjacent printed circuit.

2. A device according to claim 1, characterized in that the first portion (3) of a pin comprises a hollow portion (5) to allow insertion and contact of the first portion (3) with the second portion (4) of another pin.

3. A device according to claims 1 and 2, characterized in that the hollow portion (5) is formed by a cylindrical hole and the second portion (4) of a pin is cylindrical and has a predetermined diameter to allow establishment of contact and insertion in the hole forming the hollow portion (5) of another pin.

4. A device according to any one of claims 1 to 3, characterized in that the second portion (4) of a pin is removably attached to the first portion (3).

5. A device according to any one of claims 1 to 4, characterized in that the second portion of a pin is screwed to the first portion.

6. A device according to any one of claims 1 to 5, characterized in that each printed circuit comprises a first series of connector tabs (15) electrically connected, respectively, to the connector pins (2), and a second series of tabs (16), each electrically connected to at least one conductor of the printed circuit, to allow to establish, at will, a connection between the connector tabs of the second series and the connector tabs of the first series by means of conductor wires.

7. A device according to any one of claims 1 to 6, characterized in that the connectors comprise second pin portions (4) shorter than those that are in contact with the pins of the connector of the adjacent printed circuit, so as to allow the interconnection between the conductor of the card, without establishing the interconnection with other pins of an adjacent card.

**Patentansprüche**

1. Vorrichtung zur Zusammenschaltung von Druckschaltungskarten ($6_1$ $6_2$), welche untereinander in festen Positionen gehalten werden, mit Verbindern, die jeweils an einer Druckschaltungskarte befestigt sind und aus einem Basisblock (1) aus dielektrischem Material und einer oder mehreren metallischen Verbinderstiften bestehen, von denen jeder in mindestens zwei Abschnitte (3, 4) unterteilt ist, wobei ein erster Abschnitt (3) mit dem Basisblock verbunden und der zweite Abschnitt (4) über den Basisblock (1) vorsteht, dadurch gekennzeichnet, daß jeder zweite Abschnitt (4) eines Verbinderstifts den gedruckten Schaltkreis der Karte, an der sein Basisblock befestigt, ist, durch ein metallisiertes Loch (7) hindurch durchquert, um eine Verbindung zwischen dem Stift und mindestens einem Leiter (9) der Druckschaltung herzustellen, und daß dieser zweite Abschnitte eine einstellbare Länge besitzt, um in einer ersten Situation die direkte Kontaktierung mit dem ersten gegenüberstehenden Abschnitt (3) eines Verbinderstiftes einer benachbarten Druckschaltung zu gestatten, oder in einer zweiten Situation ihre Trennung vom gegenüberstehenden Verbinderstift der benachbarten Druckschaltung.

2. Vorrichtung nach Anspruch 1, dadurch gekennzeichnet, daß der erste Befestigungsabschnitt (3) eines Stiftes einen ausgehöhlten Abschnitt (5) aufweist, der die Einführung und den Kontakt des ersten Abschnittes (3) im zweiten Abschnitt (4) eines anderen Stiftes gestattet.

3. Vorrichtung nach den Ansprüchen 1 und 2, dadurch gekennzeichnet, daß der ausgehöhlte Abschnitt (5) aus einem zylindrischen Loch besteht und daß der zweite Abschnitt (4) eines Stiftes zylindrisch ist und einen solchen Durchmesser besitzt, der den Kontakt und seine Einführung in das Innere eines Loches gestattet, welches durch den ausgehöhlten Abschnitt (5) eines anderen Stiftes gebildet wird.

4. Vorrichtung nach einem der Ansprüche 1 bis 3, dadurch gekennzeichnet, daß der zweite Abschnitt eines Stiftes lösbar am ersten Abschnitt (3) befestigt ist.

5. Vorrichtung nach einem der Ansprüche 1 bis 4, dadurch gekennzeichnet, daß der zweite Abschnitt eines Stiftes an den ersten Abschnitt (3) angeschraubt ist.

6. Vorrichtung nach einem der Ansprüche 1 bis 5, dadurch gekennzeichnet, daß jede Druckschaltung eine erste Reihe von Anschlußenden (15), die elektrisch jeweils an die Verbindungsstifte (2) angeschlossen sind, und eine zweits Reihe von Anschlußenden (16) aufweist, von denen jedes elektrisch mit mindestens einem Leiter der Druckschaltung verbunden ist, um nach Wunsch die Verbindung der Anschlußenden der zweiten Reihe mit den Anschlußenden der ersten Reihe durch Leiterdrähte herbeizuführen.

7. Vorrichtung nach einem der Ansprüche 1 bis 6, dadurch gekennzeichnet, daß die Verbinder zweite Stiftabschnitte (4) aufweisen, welche kürzer als die in Kontakt mit den Verbinderstiften der benachbarten Druckschaltung stehenden Stiftabschnitte sind, um so die Herstellung von Verbindungen zwischen dem Leiter der Karte ohne die Herstellung der Verbindung mit anderen Stiften einer benachbarten Karte zu gestatten.

Fig.1

Fig.2

Fig.3

Fig.4

Fig.5

Fig.6